(19) Europäisches Patentamt
European Patent Office
Office européen des brevets

(11) EP 4 333 021 A2

(12) EUROPEAN PATENT APPLICATION

(43) Date of publication:
**06.03.2024 Bulletin 2024/10**

(21) Application number: **23193877.0**

(22) Date of filing: **29.08.2023**

(51) International Patent Classification (IPC):
***H01J 37/302*** (2006.01) ***H01J 37/305*** (2006.01)

(52) Cooperative Patent Classification (CPC):
**H01J 37/302; H01J 37/3056;** H01J 2237/31745; H01J 2237/31749

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **29.08.2022 JP 2022136135**

(71) Applicant: **JEOL Ltd.**
**Akishima Tokyo 196-8558 (JP)**

(72) Inventor: **KAGAYA, Yusuke**
**Tokyo 196-8558 (JP)**

(74) Representative: **Boult Wade Tennant LLP**
**Salisbury Square House**
**8 Salisbury Square**
**London EC4Y 8AP (GB)**

# (54) FOCUSED ION BEAM APPARATUS

(57) A focused ion beam apparatus (100) that machines a cross section of a specimen by scanning the specimen (S) with an ion beam, the focused ion beam apparatus includes an optical system (10) that scans the specimen with the ion beam, a receiving unit (52) that receives setting of a machining region of the specimen and setting of a plurality of machining conditions for the machining region, and a control unit (54) that controls the optical system, wherein the control unit causes the optical system to scan the machining region with the ion beam, based on the machining conditions that have been set for the machining region.

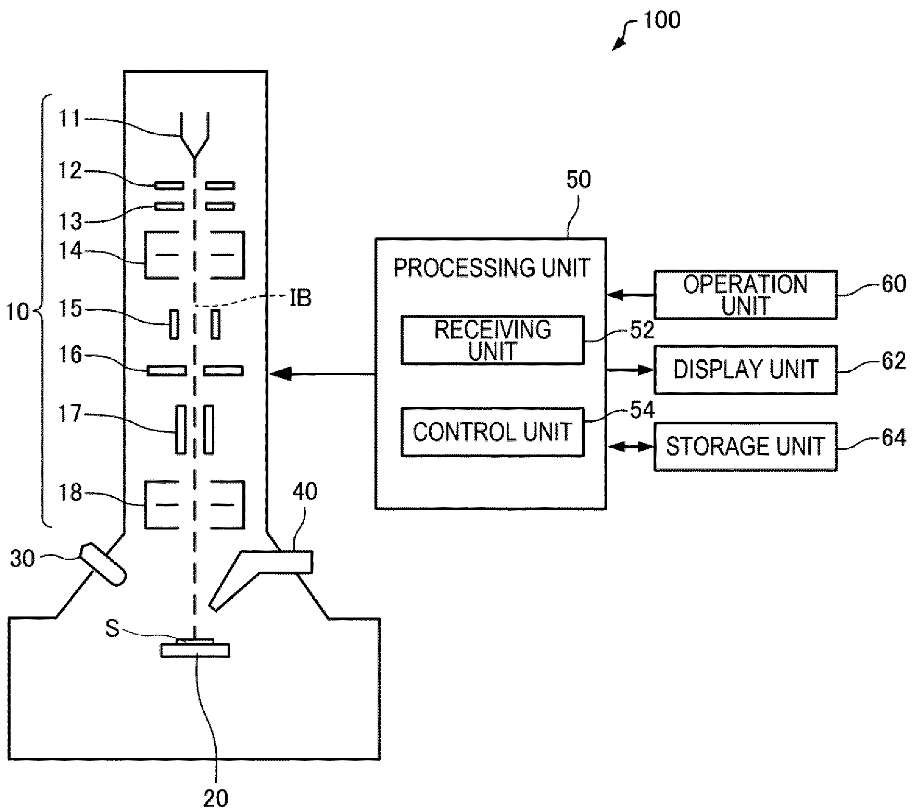


FIG. 1

EP 4 333 021 A2

## Description

### BACKGROUND OF THE INVENTION

### Field of the Invention

The present invention relates to a focused ion beam apparatus.

### Description of the Related Art

A focused ion beam apparatus is an apparatus for machining a specimen by scanning a specimen surface with a focused ion beam.

In a case of preparing a cross section of a specimen in a focused ion beam apparatus, the specimen is first roughly machined by setting an emission current of an ion beam to high, then receives finish machining, with the emission current of the ion beam being decreased. Thereby a clear cross section can be acquired in a short time. In this way, the focused ion beam apparatus continues machining while changing machining conditions such as emission current.

For example, JP-A-2006-313704 discloses a focused ion beam apparatus that automatically calculates machining conditions, such as a beam diameter, once the user inputs such data as the size of a machining region and finishing degree of machining.

In the focused ion beam apparatus disclosed in JP-A-2006-313704, only one machining condition can be set for one machining region that has been set by the user. This means that the user has to set a machining region many times to continue machining while changing machining conditions such as emission current.

### SUMMARY OF THE INVENTION

According to an aspect of the present disclosure, there is provided a focused ion beam apparatus that machines a cross section of a specimen by scanning the specimen with an ion beam, the focused ion beam apparatus including:

an optical system that scans the specimen with the ion beam;
a receiving unit that receives setting of a machining region of the specimen and setting of a plurality of machining conditions for the machining region; and
a control unit that controls the optical system, wherein
the control unit causes the optical system to scan the machining region with the ion beam, based on the machining conditions that have been set for the machining region.

### BRIEF DESCRIPTION OF THE DRAWINGS

FIG. 1 illustrates a configuration of a focused ion beam apparatus according to the first embodiment.
FIG. 2 is a flow chart illustrating an example of a cross section machining method using the focused ion beam apparatus according to the first embodiment.
FIG. 3 is a diagram schematically illustrating a GUI screen.
FIG. 4 is a diagram schematically illustrating a GUI screen.
FIG. 5 is a diagram for explaining the cross section machining method using the focused ion beam apparatus according to the first embodiment.
FIG. 6 is a flow chart illustrating an example of the cross section machining processing.
FIG. 7 is a diagram for explaining a case of setting one machining condition for one machining region.
FIG. 8 illustrates a configuration of a focused ion beam apparatus according to the second embodiment.
FIG. 9 is a flow chart illustrating an example of cross section machining processing by a processing unit of the focused ion beam apparatus according to the second embodiment.
FIG. 10 is a flow chart illustrating an example of processing to set an emission current.
FIG. 11 is a diagram for explaining a method of setting an emission current.
FIG. 12 is a diagram for explaining a method of setting an emission current.
FIG. 13 is a diagram for explaining a method of setting an emission current.

### DESCRIPTION OF THE INVENTION

According to an embodiment of the present disclosure, there is provided a focused ion beam apparatus that machines a cross section of a specimen by scanning the specimen with an ion beam, the focused ion beam apparatus including:

an optical system that scans the specimen with the ion beam;
a receiving unit that receives setting of a machining region of the specimen and setting of a plurality of machining conditions for the machining region; and
a control unit that controls the optical system, wherein
the control unit causes the optical system to scan the machining region with the ion beam, based on the machining conditions that have been set for the machining region.

In the case of this focused ion beam apparatus, a plurality of machining conditions can be set for one machining region. Therefore in this focused ion beam apparatus, the user need not set a machining region each time a machining condition is changed, and a plurality of machining conditions can be set easily.

Now preferred embodiments of the present invention will be described in detail with reference to the drawings. The embodiments described below are not intended to unduly limit the contents of the present invention described in the claims. Further, all of the components described below are not necessarily essential requirements of the present invention.

1. First embodiment

1.1. Focused Ion Beam Apparatus

A focused ion beam apparatus according to the first embodiment will be described first with reference to the drawings. FIG. 1 illustrates a configuration of a focused ion beam apparatus 100 according to the first embodiment.

As illustrated in FIG. 1, the focused ion beam apparatus 100 includes an optical system 10, a specimen stage 20, a secondary electron detector 30, a gas gun 40, a processing unit 50, an operation unit 60, a display unit 62 and a storage unit 64.

In the focused ion beam apparatus 100, a specimen S can be machined (etched) by scanning the specimen S with a focused ion beam IB. Further, in the focused ion beam apparatus 100, a deposition film can be formed on the specimen S by emitting an ion beam IB while supplying gas near the surface of the specimen S using the gas gun 40. Furthermore, in the focused ion beam apparatus 100, a scanning ion microscope (SIM) image can be acquired by scanning the specimen S with the focused ion beam IB, and detecting, by the secondary electron detector 30, electrons emitted from the specimen S.

The optical system 10 scans the specimen S with the ion beam IB. The optical system 10 includes an ion source 11, an extraction electrode 12, an acceleration electrode 13, a focusing lens 14, a beam blanking electrode 15, a variable multi-aperture 16, a beam deflection electrode 17, and an objective lens 18.

The ion source 11 generates ions. The extraction electrode 12 extracts ions from the ion source 11. The acceleration electrode 13 accelerates ions extracted from the ion source 11. Thereby ions can be accelerated at a predetermined acceleration voltage. The focusing lens 14 focuses the ion beam IB.

The ion beam blanking electrode 15 controls the ON/OFF of emission of the ion beam IB onto the specimen S. The variable multi-aperture 16 selectively limits the emission current of the ion beam IB. The variable multi-aperture 16 has a plurality of aperture holes having different diameters. In the focused ion beam apparatus 100, the emission current of the ion beam IB can be controlled by selecting an aperture hole that is disposed on the path of the ion beam IB.

The beam deflection electrode 17 deflects the ion beam IB. By deflecting the ion beam IB using the beam deflection electrode 17, the specimen S can be two-dimensionally scanned with the ion beam IB. The objective lens 18 focuses the ion beam IB.

The specimen stage 20 supports the specimen S. The specimen stage 20 can move the specimen S in the horizontal direction. The specimen stage 20 can also rotate or tile the specimen S.

The secondary electron detector 30 detects secondary electrons generated in the specimen S when the specimen S is irradiated with the ion beam IB. A detection signal (intensity signal) of the secondary electrons detected by the secondary electron detector 30 is sent to the processing unit 50 as image data synchronizing with the scanning with the ion beam IB. The processing unit 50 generates a SIM image based on the image data, and causes the display unit 62 to display the SIM image.

The gas gun 40 supplies a compound gas to the surface of the specimen S. When the ion beam IB is emitted to a surface of the specimen S filled with compound gas, the compound gas decomposes by the secondary electrons generated by the ion beam IB emitted to the specimen S. The decomposed compound gas is adsorbed and deposited on the specimen surface. Thereby a deposition film is formed. For example, if $W(CO)_6$ is used as the compound gas, a tungsten film is formed.

The operation unit 60 acquires an operation signal in accordance with an operation performed by the user, and sends the operation signal to the processing unit 50. The operation unit 60 is such an input device as a button, key, touch panel type display, and microphone, for example. The user can set a machining region and machining condition using the operation unit 60.

The display unit 62 displays an image generated by the processing unit 50. The display unit 62 can be implemented using such a display as a liquid crystal display (LCD). A graphical user interface (GUI) screen and a SIM image are displayed on the display unit 62, for example.

The storage unit 64 stores programs and data for the processing unit 50 to perform various computing processing and control processing. The storage unit 64 is also used as a work area of the processing unit 50. For example, the storage unit 64 can be implemented by a random access memory (RAM), a read only memory (ROM), a hard disk, and the like.

The functions of the processing unit 50 can be implemented by various processors (e.g., central processing unit (CPU)) executing programs. At least a part of the functions of the processing unit 50 may be implemented by a dedicated circuit, such as ASIC (e.g., gate array). The processing unit 50 includes a receiving unit 52 and a control unit 54.

The receiving unit 52 receives the setting of a machining region and a setting of a plurality of machining conditions for one machining region. The control unit 54 controls the optical system 10, the specimen stage 20, the secondary electron detector 30, and the gas gun 40. Details on the processing of the receiving unit 52 and the control unit 54 will be described later.

1.2. Operation

In the focused ion beam apparatus 100, a machining region can be machined based on a plurality of machining conditions which are set for one machining region. A cross section machining method using the focused ion beam apparatus 100 will be described below.

FIG. 2 is a flow chart illustrating an example of the cross section machining method using the focused ion beam apparatus 100.

(1) Processing Step S100 to Set Machining Region and Finish Surface

First, the user sets a machining region and a finish surface. FIG. 3 is a diagram schematically illustrating a GUI screen 2.

The receiving unit 52 displays the GUI screen 2 on the display unit 62. A region 2A to set a machining region is displayed on the GUI screen 2.

A SIM image 4 of a surface of a specimen S is displayed in the region 2A. The user can set the machining region by drawing a machining frame 6 on the SIM image 4. A region of the specimen S corresponding to the region on the SIM image 4 enclosed by the machining frame 6 is set as the machining region. The machining frame 6 is a square, for example, and the size and aspect ratio thereof can be changed.

The user can set a position of a finish surface by specifying one side of the machining frame 6 on the SIM image 4. The finish surface is a final surface that is machined by the ion beam IB, and becomes the cross section (machining target) of the specimen S. The direction of scanning with the ion beam IB is determined by setting the position of the finish surface. In the example in FIG. 3, a side 7 of the machining frame 6 is specified as the finish surface, and scanning with the ion beam IB is started from a side 8 on the opposite side of the side 7.

The setting of the machining region and the setting of the finish surface are performed by the user via the operation unit 60.

(2) Processing Step S102 to Set Machining Conditions

Next the user sets the machining conditions. FIG. 4 is a diagram schematically illustrating the GUI screen 2.

An entry field 2B to set the machining conditions is displayed on the GUI screen 2. A plurality of machining conditions can be set for one machining region. The machining conditions can be set for each scanning line. Here the case of setting an emission current Ip of the ion beam IB will be described.

The emission current Ip can be set for each scanning line. In the case of scanning the machining region with the ion beam IB here, a scanning line is drawn one-dimensionally, and the ion beam IB is moved in the direction perpendicular to the direction of the scanning line, then a next scanning line is drawn, and this process is repeated.

In the case of the example in FIG. 4, after a first scanning line L1 is drawn, the ion beam IB is moved in a direction perpendicular to the first scanning line L1, then a second scanning line L2 is drawn parallel with the first scanning line L1. The scanning lines from a third scanning line L3 to an Nth scanning line LN are also drawn in the same manner, whereby the machining region can be etched.

A number of scanning lines N is determined by the machining conditions (e.g., emission current (beam diameter)). It is also possible that after drawing the first scanning line L1 for a plurality of times at a same position, the ion beam IB is moved in a direction perpendicular to the first scanning line L1, then the second scanning line L2 is drawn for a plurality of times. In other words, a scanning line may be drawn for a plurality of times at a same position. Thereby the specimen S can be etched more deeply.

By the user inputting the current amount for each scanning line in the entry field 2B via the operation unit 60, the emission current Ip can be set for each scanning line. In the case of the example in FIG. 4, the emission current Ip, when the first scanning line L1 is drawn, is set to 90 nA. The emission current Ip, when the scanning lines from the second scanning line L2 to the fifth scanning line L5 are drawn, is set to 90 nA. The emission current Ip, when the scanning lines from the sixth scanning line L6 to the ninth scanning line L9 are drawn, is set to 50 nA. Further, the emission current Ip, when the (N-3)th scanning line LN-3, the (N-2)th scanning line LN-2, and the (N-1)th scanning line LN-1 are drawn, is set to 10 nA. Furthermore, the emission current Ip, when the Nth scanning line LN is drawn, is set to 1 nA.

The emission current Ip may be set for the block from the first scanning line L1 to the fifth scanning line L5 by inputting 90 nA as the emission current Ip for the block from the first scanning line L1 to the fifth scanning line L5. In this way, one emission current Ip value may be set for a plurality of scanning lines L at one time.

In the above description, setting the emission current Ip as a machining condition is described, but items of the machining conditions are not limited to the emission current Ip. Besides the emission current Ip, the items of the machining conditions include a machining pitch, a dwell time, machining time, acceleration voltage, machining position offset, and the like.

The machining pitch is a distance between the scanning points of adjacent ion beams IB when the scanning lines are drawn. The dwell time is a dwell time of the ion beam IB at each scanning point. The machining time is a time required for one scanning line to scan, and if a time twice the time required for drawing one scanning line is set as the machining time, the scanning line is drawn twice at a same position. In other words, if a time twice the time required for drawing the first scanning line L1 is set as the machining time for the first scanning line L1, the first scanning line L1 is drawn twice. The acceleration voltage is a voltage to accelerate the ion beam IB. And the machining position offset is for determining the edge position of the ion beam IB, and is expressed by a distance between the center of the ion beam IB and the edge of the ion beam IB. As the beam diameter decreases, the machining position offset also decreases.

Each item of the machining conditions described above as well can be set for each scanning line L, in the same manner as the case of the emission current Ip. Each item of the machining conditions is set by inputting a value of each item for each scanning line in the entry field via the operation unit 60, in the same manner as the case of setting the emission current Ip.

(3) Processing Step S104 to Set Repeat Count

Next a number of times of repeating the machining is set. An entry field 2C for setting a number of times of repeating the machining is displayed on the GUI screen 2. The number of times of repeating the machining is set by using drawing of the first scanning line L1 to the Nth scanning line LN in the machining region as one machining unit. In other words, one time of machining is drawing the first scanning line L1 to the Nth scanning line LN. The repeat count can be set by the user inputting the repeat count in the entry field 2C via the operation unit 60. By repeating the machining, the machining region A can be machined more deeply.

(4) Processing Step S106

FIG. 5 is a diagram for explaining a cross section machining method using the focused ion beam apparatus 100.

First a deposition film is formed using the gas gun 40, so as to cover the entire machining region A. Thereby the deposition film formed on the specimen S can protect the specimen S.

Then a machining region A is machined. The focused ion beam apparatus 100 machines the machining region A of the specimen S set in the processing step S 100, based on the machining conditions set in the processing step S 102, and the repeat count set in the processing step S104.

Specifically, the machining region A is etched by the optical system 10 drawing the scanning lines in the machining region A, from the first scanning line L1 to the Nth scanning line LN. To draw the first scanning line L1, the optical system 10 operates based on the machining conditions set for the first scanning line L1. In other words, when the first scanning line L1 is drawn, the optical system operates in accordance with the emission current Ip, the machining pitch, the dwell time, the machining time, the acceleration voltage, and the machining position offset, which were set for the first scanning line L1. In the case of the example in FIG. 4, 90 nA is set as the emission current Ip when drawing the first scanning line L1, hence the optical system 10 draws the first scanning line L1 at the emission current Ip = 90 nA. In the case of drawing other scanning lines L as well, the optical system 10 operates in the same manner, in accordance with the machining conditions set for each scanning line.

The optical system 10 repeats the machining to draw the scanning lines from the first scanning line L1 to the Nth scanning line LN for a number of times which was set in the processing step S104.

As a result, the machining region A can be etched, and a target cross section can be acquired.

1.3. Processing operations

FIG. 6 is a flow chart illustrating an example of the cross section machining processing by the processing unit 50 of the focused ion beam apparatus 100.

When the user sets the machining region A, the finish surface F, the machining conditions and the repeat count via the operation unit 60, the receiving unit 52 receives the setting of the machining region A, the finish surface F, the machining conditions and the repeat count, set by the user (S200).

The receiving unit 52 stores the information on the machining region A, the information on the finish surface F, and the information on the machining conditions, set by the user, in the storage unit 64. The information on the machining conditions is set for each scanning line, and is stored in the storage unit 64 for each scanning line.

Then the control unit 54 causes the optical system 10 to machine the machining region A, based on the information on the machining region A, the finish surface F, and the machining conditions, received by the receiving unit 52 (S202).

The control unit 54 reads optical conditions to draw the first scanning line L1 from the storage unit 64, and controls the optical system 10 based on the optical conditions. Thereby the first scanning line L1 is drawn on the specimen S. In the same manner, the control unit 54 reads the optical conditions to draw the second scanning line L2 from the storage unit 64, and controls the optical system 10 based on the optical conditions. Thereby the second scanning line L2 is drawn on the specimen S. The control unit 54 draws the scanning lines, from the first scanning line L1 to the Nth scanning line LN, in the same manner.

For example, in the case where the emission current Ip set for the fifth scanning line L5 and the emission current Ip set for the sixth scanning line L6 are different, as illustrated in FIG. 4, the control unit 54 causes the optical system 10 to stop scanning with the ion beam IB after drawing the fifth scanning line L5 and before drawing the sixth scanning line L6, so as to switch the emission current Ip. Further, the control unit 54 adjusts the contrast and the brightness in order to correct the change of the contrast and the brightness caused by switching of the emission current Ip. Furthermore, the control unit 54 adjusts focus in order to correct the shift of focus caused by switching of the emission current Ip. Moreover, the control unit 54 corrects the shift of the machining position caused by switching of the emission current Ip.

The control unit 54 causes the optical system 10 to draw the scanning lines from the first scanning line L1 to the Nth scanning line LN, then determines whether the machining region A has been machined for the set number of times (S204).

If it is determined that the machining region A has not been machined for the set number of times (No in S204), the control unit 54 returns to the processing step S202, and causes the optical system 10 to machine the machining region A (S202). The control unit 54 repeats the processing step S202 until it is determined that the machining region A has been processed for the set number of times.

If it is determined that the machining region A has been machined for the set number of times (Yes in S204), the control unit 54 ends the cross section machining processing.

1.4. Effect

In the focused ion beam apparatus 100, the receiving unit 52 sets the machining region A of the specimen S, and receives the setting of a plurality of machining conditions for one machining region A, and the control unit 54 causes the optical system 10 to scan the machining region A with the ion beam IB based on the plurality of machining conditions which are set for the one machining region A. Therefore in the focused ion beam apparatus 100, a plurality of machining conditions can be set for one machining region A. That is, the user need not set the machining region A every time the machining condition is changed, and can easily set a plurality of machining conditions.

FIG. 7 is a diagram for explaining a case of setting one machining condition for one machining region.

In the case where only one machining condition can be set for one machining region, the user must set a machining region each time a machining condition is changed, as illustrated in FIG. 7. Whereas in the focused ion beam apparatus 100, a plurality of machining conditions can be set for one machining region A, hence a plurality of machining conditions can be set easily compared with the case where only one machining condition can be set for one machining region.

Further, in the case where only one machining condition can be set for one machining region, the next machining region and the next machining conditions can be set unless the previous machining ends, as illustrated in FIG. 7. Whereas in the focused ion beam apparatus 100, a plurality of machining conditions can be set for one machining region, hence such a problem does not occur. For example, in the case of the focused ion beam apparatus 100, once a machining region and a plurality of machining conditions are initially set, the machining region and the machining conditions need not be set until the machining ends.

In the focused ion beam apparatus 100, the receiving unit 52 receives the setting of the machining conditions for each scanning line L, and based on the machining conditions which are set for each scanning line, the control unit 54 causes the optical system 10 to scan the machining region A with the ion beam IB. Therefore in the focused ion beam apparatus 100, the machining conditions can be changed for each line when the specimen S is machined. This means that in the focused ion beam apparatus 100, the machining conditions can be changed consecutively.

2. Second embodiment

2.1. Focused Ion Beam Apparatus

A focused ion beam apparatus according to the second embodiment will be described next with reference to the drawings. FIG. 8 illustrates a configuration of the focused ion beam apparatus 200 according to the second embodiment. In the focused ion beam apparatus 200 according to the second embodiment, a composing member having a same function as a composing member of the focused ion beam apparatus 100 according to the first embodiment is denoted with the same reference sign, and detailed description thereof will be omitted.

In the above mentioned focused ion beam apparatus 100 according to the first embodiment, the user sets the emission current Ip of the ion beam IB. In the focused ion beam apparatus 200 according to the second embodiment, on the other hand, the processing unit 50 includes a setting unit 53 which sets the emission current Ip of the ion beam IB.

2.2. Processing operations

FIG. 9 is a flow chart illustrating an example of the cross section machining processing by the processing unit 50 of the focused ion beam apparatus 200. In the following, aspects different from the above mentioned processing steps of the processing unit 50 in FIG. 6 will be described, and description on aspect the same as the above mentioned processing steps of the processing unit 50 in FIG. 6 will be omitted.

When the user sets the machining region A, the finish surface F, the machining conditions (excluding the emission current Ip), and the repeat count via the operation unit 60, the receiving unit 52 receives the setting of the machining region A, the finish surface F, the machining conditions (excluding the emission current Ip), and the repeat count, set by the user (S300). The receiving unit 52 causes the storage unit 64 to store the received information on the machining region A, the finish surface F, the machining conditions (excluding the emission current Ip), and the repeat count.

Then the setting unit 53 sets the emission current Ip for each scanning line (S302). The processing for setting the emission current Ip will be described later. The receiving unit 52 receives the setting of the emission current Ip performed by the setting unit 53 (S303).

Then the control unit 54 causes the optical system 10 to machine the machining region A, based on the information on the machining region A, the finish surface F, and the machining conditions (including the emission current Ip), received by the receiving unit 52 (S304).

The control unit 54 reads the optical conditions to draw the first scanning line L1 from the storage unit 64, and controls the optical system 10 based on these optical conditions. Thereby the first scanning line L1 is drawn on the specimen S. In the same manner, the control unit 54 reads the optical conditions to draw the second scanning line L2, from the storage unit 64, and controls the optical system 10 based on these optical conditions. Thereby the second scanning line L2 is drawn on the specimen S. The control unit 54 repeats the same processing from the first scanning line L1 to the Nth scanning line LN.

The control unit 54 causes the optical system 10 to draw the scanning lines from the first scanning line L1 to the Nth scanning line LN, then determines whether the machining region A has been machined for the set number of times (S306).

If it is determined that the machining region A has not been machined for the set number of times (No in S306), the control unit 54 returns to the processing step S304, and causes the optical system 10 to machine the machining region A based on the information on the machining region A, the finish surface F, and the machining conditions (S304). The control unit 54 repeats the processing step S304 until it is determined that the machining region A has been machined for the set number of times.

If it is determined that the machining region A has been machined for the set number of times (Yes in S306), the control unit 54 ends the cross section machining processing.

FIG. 10 is a flow chart illustrating an example of the processing step S302 to set the emission current Ip. FIGS. 11 to 13 are diagrams for explaining a method of setting the emission current Ip.

First the setting unit 53 sets a first emission current Ip-1 based on the set machining region A, as illustrated in FIG. 11 (S400).

The first emission current Ip-1 is the maximum emission current out of the emission currents Ip of the ion beam IB which are used to machine the machining region A.

The setting unit 53 sets the first emission current Ip-1 based on a machining width W of the machining region A, for example. The machining width W is the size of the machining region A in the direction of drawing the scanning line L. The setting unit 53 sets the first emission current Ip-1 to a larger value as the machining width W becomes larger. By setting the first emission current Ip-1 based on the machining width W, a larger emission current can be used for machining as the machining width W becomes larger, hence the machining region A can be machined efficiently in a short time.

For example, the maximum emission current out of the emission currents that satisfy the following conditional expression (1) is set as the first emission current Ip-1.

$$(W/D) > 100 \ldots (1)$$

Here W is the machining width, and D is the beam diameter (diameter) of the ion beam IB. The beam diameter D of the ion beam IB corresponds to the emission current Ip. The beam diameter D is larger as the emission current Ip increases.

The storage unit 64 stores a table associating the beam diameter and the emission current Ip. The setting unit 53 may use this table to determine the emission current Ip from the beam diameter that satisfies the above conditional expression (1). The storage unit 64 also stores a relational expression that associates the beam diameter and the emission current Ip, and the setting unit 53 may use this relational expression to determine the emission current Ip from the beam diameter that satisfies the above conditional expression (1).

The method of determining the first emission current Ip-1, however, is not limited to the above examples, but the first emission current Ip-1 may be set based on the surface area of the set machining region A, for example. In other words, the first emission current Ip-1 may be set to be larger as the surface area of the machining region A becomes larger. The setting unit 53 may also determine the first emission current Ip-1 from the surface area of the machining region A, using the table or the relational expression which is stored in the storage unit 64 and associates the surface area of the machining region A and the first emission current Ip-1. By setting the first emission current Ip-1 based on the surface area of the machining region A, the machining region A can be machined at a larger emission current as the surface area of the machining region A is larger, hence the machining region A can be machined efficiently in a short time. Further, a maximum emission current may be set based on the size of the set machining region A in the direction perpendicular to the direction of drawing the scanning lines L.

Then the setting unit 53 sets a first region A1 to be machined with the first emission current Ip-1 (S402).

Based on the first emission current Ip-1, the setting unit 53 sets the first region A1 to be machined with the first emission current Ip-1. The setting unit 53 sets the first region A1 such that a distance D1 to the finish surface F becomes larger as the first emission current Ip-1 is larger. The distance D1 is the shortest distance of the distances between the finish surface F and the first region A1 in the direction perpendicular to the direction of drawing the scanning line L.

For example, the storage unit 64 stores a table associating the emission current Ip and a distance at which the finish surface F is not damaged when this emission current Ip is used for machining. The setting unit 53 refers to this table to acquire information on the distance D1 from the first emission current Ip-1. The setting unit 53 sets the first region A1 based on the acquired information on the distance D1. In other words, the setting unit 53 sets a region that is distant from the finish surface F by at least the distance D 1, out of the machining region A, as the first region A1.

By setting the first region A1 based on the first emission current Ip-1, the machining time can be decreased while reducing damage that the ion beam IB may cause on the finish surface F.

The setting unit 53 sets a number of scanning lines L in the first region A1 based on the first emission current Ip-1 (beam diameter), and the size of the first region A1 in the direction perpendicular to the direction of drawing the scanning line L in the first region A1.

In the example in FIG. 11, a number of the scanning lines L in the first region A1 is 5, and 5 scanning lines, from the first scanning line L1 to the fifth scanning line L5, are drawn in the first region A1. The first emission current Ip-1 is set to 80 nA for each scanning line of the first scanning line L1 to the fifth scanning line L5.

Here the emission current is used as a parameter to set the first region A1, but the parameter to set the first region A1 may be any value based on the beam diameter.

Then the setting unit 53 sets a second emission current Ip-2 in a second region A2 which is machined after the first region A1 (S404), as illustrated in FIG. 12.

The setting unit 53 sets the second emission current Ip-2 based on the first emission current Ip-1. The setting unit 53 sets the second emission current Ip-2 to be a smaller current amount than the first emission current Ip-1. For example, the setting unit 53 sets an emission current to acquire a beam diameter that is 1/2 of the beam diameter acquired with the first emission current Ip-1, as the second emission current Ip-2. The setting unit 53 may set the emission current to acquire a beam diameter that is 1/4 of the beam diameter acquired with the first emission current Ip-1, as the second emission current Ip-2.

Then the setting unit 53 sets the second region A2 to be machined with the second emission current Ip-2 (S406).

The setting unit 53 sets the second region A2 using the same method as the method of setting the first region A1. In other words, the setting unit 53 sets the second region A2 based on the second emission current Ip-2. The setting unit 53 sets the second region A2 such that a distance D2 to the finish surface F becomes larger as the second emission current Ip-2 is larger.

The setting unit 53 sets a number of scanning lines L in the second region A2 based on the second emission current Ip-2 (beam diameter), and the size of the second region A2 in the direction perpendicular to the direction of the drawing the scanning line L in the second region A2.

The setting unit 53 acquires the information on the distance D2 from the second emission current Ip-2, with reference to a table associating the emission current Ip and a distance at which the finish surface F is not damaged when this emission current Ip is used for machining. The setting unit 53 sets the second region A2 based on the acquired information on the distance D2. In other words, the setting unit 53 sets a region that is distant from the finish surface F by at least the distance D2, out of the machining region A, excluding the first region A1, as the second region A2.

In the example in FIG. 12, a number of scanning lines L in the second region A2 is 4, and the scanning lines, from the sixth scanning line L6 to the ninth scanning line L9, are drawn in the second region A2. The second emission current Ip-2 is set to 40 nA for each scanning line of the sixth scanning line L6 to the ninth scanning line L9.

The setting unit 53 determines whether the second emission current Ip-2 satisfies the machining conditions for machining the finish surface F (S408).

The setting unit 53 determines that the second emission current Ip-2 satisfies the machining conditions for machining the finish surface F if the following conditional expression (2) is satisfied.

$$(W/D) > 2000 \ldots (2)$$

The setting unit 53 determines that the emission current Ip becomes the emission current with which the finish surface F can be machined if the beam diameter D becomes sufficiently small with respect to the machining width W. In the above conditional expression (2), it is determined that the machining conditions for machining the finish surface F is satisfied if the beam diameter D becomes less than 1/2000 of the machining width W.

If it is determined that the second emission current Ip-2 does not satisfy the machining conditions for machining the finish surface F (No in S410), the setting unit 53 returns to the processing step S404, and sets a third emission current Ip-3 based on the second emission current Ip-2 (S404). The third emission current Ip-3 is set to an emission current to acquire a beam diameter that is 1/2 of the beam diameter acquired with the second emission current Ip-2, in the same manner as the case of setting the second emission current Ip-2.

Then the setting unit 53 sets a third region A3 to be machined with the third emission current Ip-3 based on the third emission current Ip-3 (S406). The third region A3 is set based on the third emission current Ip-3 (beam diameter acquired with the third emission current Ip-3), just like the case of setting the second region A2.

Then the setting unit 53 determines whether the third emission current Ip-3 satisfies the machining conditions for machining the finish surface F (S408). In this way, the setting unit 53 repeats the processing steps S404, S406, S408 and S410 until the emission current Ip satisfies the machining conditions for machining the finish surface F.

In other words, as illustrated in FIG. 13, the setting unit 53 sets the Mth emission current Ip-M (M is an integer that is at least 2 and not more than N) to an emission current with which a beam diameter that is 1/2 of a beam diameter acquired with the (M-1)th emission current Ip-(M-1) (S404), and sets the Mth region AM based on the Mth emission current Ip-M (beam diameter acquired with the Mth emission current Ip-M) (S406).

When it is determined that the Mth emission current Ip-M satisfies the machining condition for machining the finish surface F (Yes in S410), the setting unit 53 ends the processing to set the emission current.

By the above processing steps, the emission current Ip can be set for each scanning line L.

In the above conditional expression (2), the upper limit of the beam diameter D is set, but both the upper limit and the lower limit of the beam diameter D may be set as well. For example, in the processing step S408 which determines whether the machining condition for machining the finish surface F is satisfied after setting the Mth emission current Ip-M, it may be determined that the machining condition for machining the finish surface F is satisfied if the following conditional expression (3) is satisfied.

$$2000 < (W/D) < 10000 \ldots (3)$$

When it is determined that the beam diameter acquired with the Mth emission current Ip-M becomes 1/10000 of the machining width W or less, the setting unit 53 sets the Mth emission current Ip-M to a current amount with which the beam diameter D that satisfies the relational expression (3) can be acquired, and ends the processing to set the emission current Ip.

2.3. Effect

The focused ion beam apparatus 200 includes the setting unit 53 to set the emission current Ip of the ion beam IB, and the setting unit 53 sets the first emission current Ip-1 which is the maximum emission current of the ion beam IB based on the set machining region A. Therefore in the focused ion beam apparatus 200, the step for the user to set the maximum emission current can be omitted.

In the focused ion beam apparatus 200, the first emission current Ip-1 is set based on the machining width W of the machining region A. Therefore in the focused ion beam apparatus 200, the step for the user to set the maximum emission current can be omitted.

In the focused ion beam apparatus 200, the first emission current Ip-1 may be set based on the surface area of the machining region A. Therefore in the focused ion beam apparatus 200, the step for the user to set the maximum emission current can be omitted.

In the focused ion beam apparatus 200, the setting unit 53 sets the first region A1 which is machined with the first emission current Ip-1 out of the machining region A, based on the first emission current Ip-1. Therefore in the focused ion beam apparatus 200, the step for the user to set the first region A1 which is machined with the maximum emission current can be omitted.

In the focused ion beam apparatus 200, the setting unit 53 sets the second emission current Ip-2 in the second region A2 which is machined after the first region A1, based on the first emission current Ip-1, and sets the second region A2 based on the second emission current Ip-2. Further, in the focused ion beam apparatus 200, the receiving unit 52 receives the setting of the position of the finish surface F which is the cross section of the specimen S that is a machining target. The setting unit 53 sets the second region A2 so that the distance D2 between the cross section of the specimen S which is a machining target and the second region A2 becomes smaller than the distance D1 between the finish surface F and the first region A1. Therefore in the focused ion beam apparatus 200, the step for the user to set the second region A2 to be machined with the second emission current Ip-2 can be omitted.

In this way, in the focused ion beam apparatus 200, the emission current Ip is automatically set, hence machining conditions appropriate for the desired cross section to be prepared can be set, even without having knowledge on the capability of the focused ion beam apparatus 200.

2.4. Modifications

In the above mentioned processing step S302 to set the emission current Ip illustrated in FIG. 10, the setting unit 53 sets the first emission current Ip-1 based on the machining width W of the machining region A (S400). However, the setting unit 53 also may set the first emission current Ip-1 by presenting a plurality of candidates of the first emission current Ip-1, and receiving a candidate selected by the user.

As the candidates of the first emission current Ip-1, the setting unit 53 presents a plurality of candidates out of the emission currents that satisfy the above conditional expression (1).

For example, the setting unit 53 presents the emission current with which the maximum beam diameter D can be acquired out of the beam diameters D that satisfy the conditional expression (1), as the first candidate of the first emission current Ip-1; the emission current which is less than the emission current of the first candidate at a predetermined ratio, as the second candidate thereof; and the emission current which is less than the emission current of the second candidate at a predetermined ratio, as the third candidate thereof. The first candidate, the second candidate and the third candidate are displayed on the display unit 62.

The method of determining the candidates is not especially limited, and the emission current with which the maximum beam diameter D can be acquired out of the beam diameters D that satisfy the conditional expression (1), may be presented as the first candidate of the first emission current Ip-1; the emission current of which current amount is more than the first candidate at a predetermined ratio may be presented as the second candidate thereof; and the emission current of which current amount is less than the first candidate at a predetermined ratio, may be presented as the third candidate thereof. A number of candidates that are presented is not especially limited either, and the number of candidates may be 3 or more.

The user selects one candidate from the plurality of candidates that are presented. The user can select one of the plurality of candidates via the operation unit 60. The setting unit 53 receives the selection of the candidate performed by the user via the operation unit 60. Thereby the first emission current Ip-1 is set.

By the user selecting one from the plurality of candidates of the first emission current Ip-1 presented by the setting unit 53 like this, the first emission current Ip-1 can be set.

The setting unit 53 may also present a plurality of candidates in the same manner for the processing step S404 to set the Mth emission current Ip-M (M is an integer that is at least 2 and not more than N), and set the Mth emission current Ip-M by receiving the selection of the candidate performed by the user.

For example, as the candidates of the Mth emission current Ip-M, the setting unit 53 may present an emission current, to acquire a beam diameter that is 1/2 of the beam diameter acquired with the (M-1)th emission current Ip-(M-1), as the first candidate; present an emission current, to acquire a beam diameter that is 1/4 of the beam diameter acquired with the (M-1)th emission current Ip-(M-1), as the second candidate; and present an emission current, to acquire a beam diameter that is 1/8 of the beam diameter acquired with the (M-1)th emission current Ip-(M-1), as the third candidate.

3. Modifications

The present invention is not limited to the above mentioned embodiments, but may be modified in various ways within the scope of the present invention.

For example, in the case of the second embodiment described above, the setting unit 53 sets the emission current Ip, but the setting unit 53 may set an acceleration voltage instead.

The acceleration voltage also corresponds to the beam diameter D, just like the case of the emission current Ip, hence the setting unit 53 may set a first acceleration voltage which is the maximum acceleration voltage, based on the machining region A, in the same manner as the case of setting the first emission current Ip-1. Further, the setting unit 53 may set a second acceleration voltage to machine the second region A2, based on the set first acceleration voltage.

In this way, the setting unit 53 may set the acceleration voltage in the same manner as the case of setting the emission current Ip.

The invention is not limited to the above-described embodiments, and various modifications can be made. For example, the invention includes configurations that are substantially the same as the configurations described in the embodiments. Substantially same configurations mean configurations having the same functions or methods, for example. The invention also includes configurations obtained by replacing non-essential elements of the configurations described in the embodiments with other elements. The invention further includes configurations obtained by adding known art to the configurations described in the embodiments.

**Claims**

1. A focused ion beam apparatus that machines a cross section of a specimen by scanning the specimen with an ion beam, the focused ion beam apparatus comprising:

    an optical system that scans the specimen with the ion beam;
    a receiving unit that receives setting of a machining region of the specimen and setting of a plurality of machining conditions for the machining region; and
    a control unit that controls the optical system, wherein
    the control unit causes the optical system to scan the machining region with the ion beam, based on the machining conditions that have been set for the machining region.

2. The focused ion beam apparatus according to claim 1, wherein
    the machining conditions include an emission current of the ion beam.

3. The focused ion beam apparatus according to claim 1 or 2, wherein

    the receiving unit receives setting of the machining conditions for respective scanning lines to scan the machining region with the ion beam, and
    the control unit causes the optical system to scan the machining region with the ion beam, based on the machining conditions that have been set for respective scanning lines.

4. The focused ion beam apparatus according to claim 1, further comprising

a setting unit that sets the machining conditions, wherein
the machining conditions include an emission current of the ion beam, and
the setting unit sets a first emission current that is a maximum emission current of the ion beam, based on the set machining region.

5. The focused ion beam apparatus according to claim 4, wherein
the setting unit sets the first emission current, based on a size of the machining region in a direction of drawing the scanning lines.

6. The focused ion beam apparatus according to claim 4, wherein
the setting unit sets the first emission current, based on a surface area of the machining region.

7. The focused ion beam apparatus according to claim 4, wherein
the setting unit sets a first region that is part of the machining region and is machined with the first emission current, based on the first emission current.

8. The focused ion beam apparatus according to claim 7, wherein

the setting unit
sets a second emission current for a second region that is part of the machining region and is machined after the first region, based on the first emission current, and then
sets the second region based on the second emission current.

9. The focused ion beam apparatus according to claim 8, wherein

the receiving unit receives setting of a position of a cross section of the specimen that is a machining target, and
the setting unit sets the second region so that a distance between the cross section of the specimen that is the machining target, and the second region becomes smaller than a distance between the cross section of the specimen that is the machining target, and the first region.

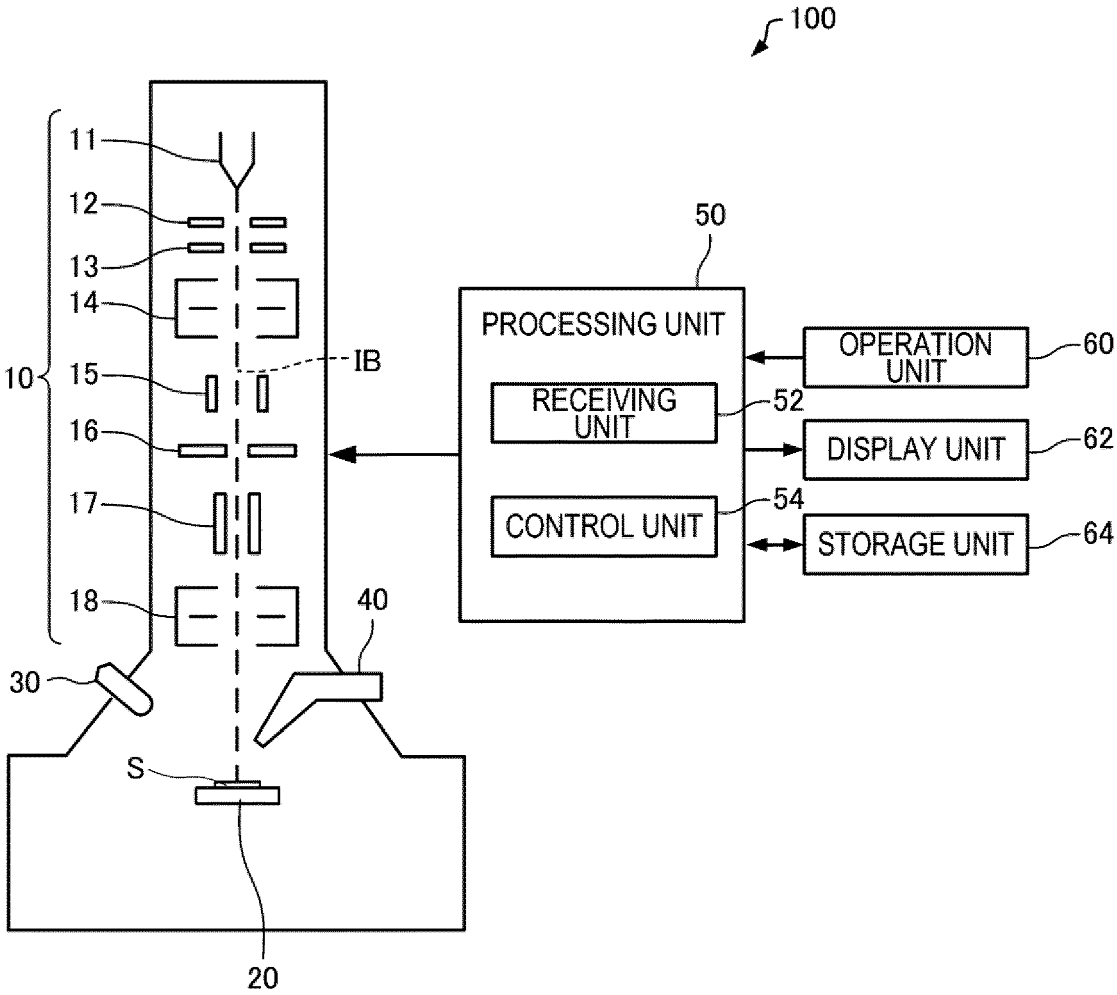
100
11
12
13
14
10
15
IB
16
17
18
30
40
S
20
50
PROCESSING UNIT
RECEIVING UNIT
52
CONTROL UNIT
54
OPERATION UNIT
60
DISPLAY UNIT
62
STORAGE UNIT
64

FIG. 1

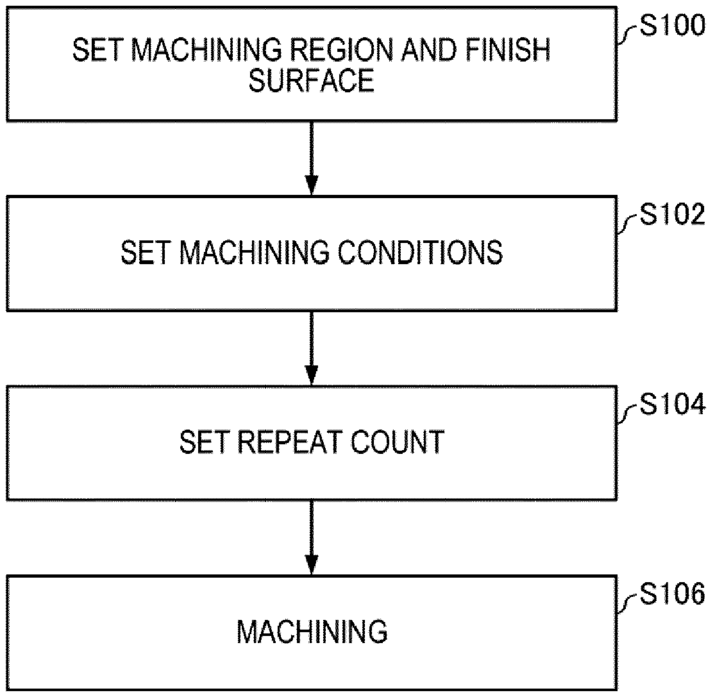
SET MACHINING REGION AND FINISH SURFACE
S100
SET MACHINING CONDITIONS
S102
SET REPEAT COUNT
S104
MACHINING
S106

FIG. 2

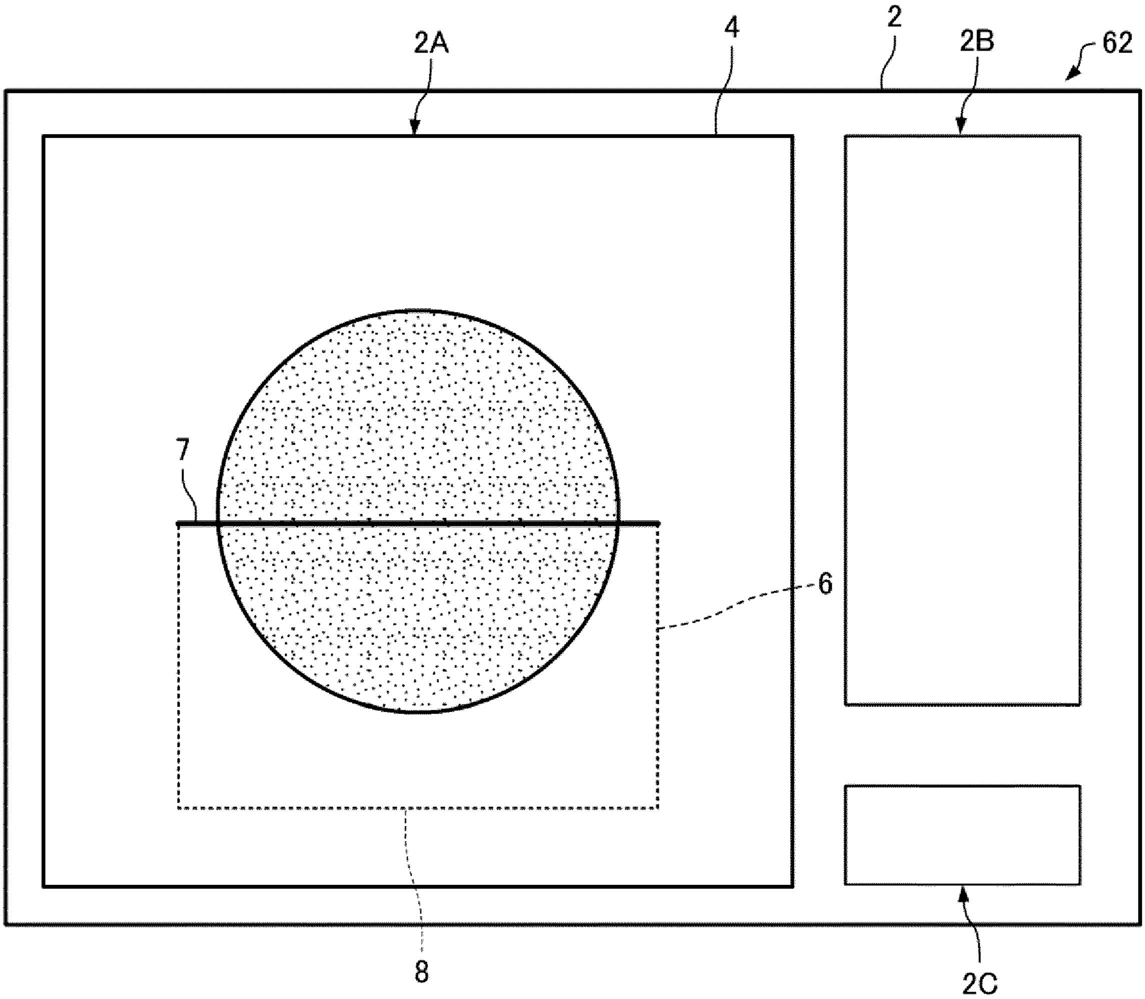


FIG. 3

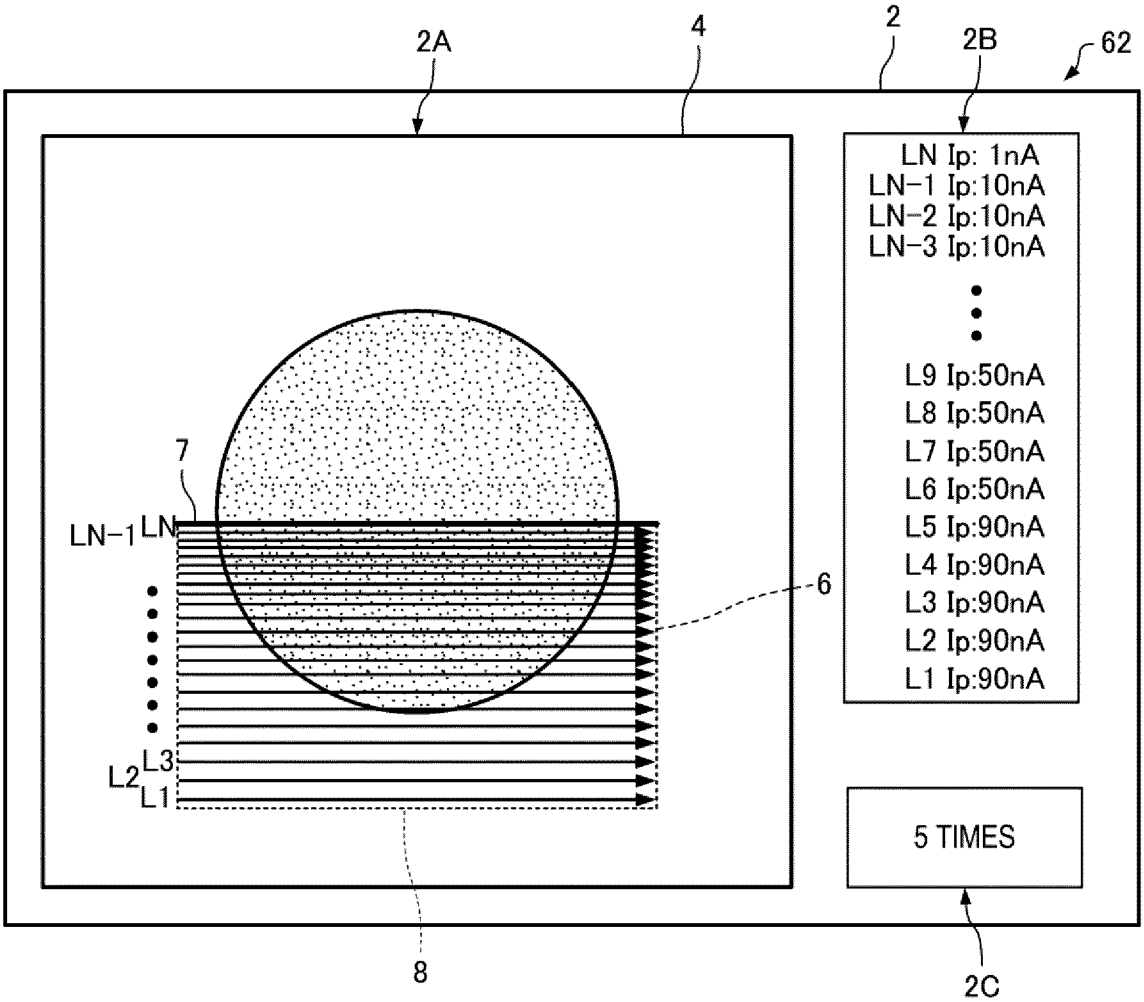
2A
4
2
2B
62
LN Ip: 1nA
LN-1 Ip:10nA
LN-2 Ip:10nA
LN-3 Ip:10nA
L9 Ip:50nA
L8 Ip:50nA
L7 Ip:50nA
L6 Ip:50nA
L5 Ip:90nA
L4 Ip:90nA
L3 Ip:90nA
L2 Ip:90nA
L1 Ip:90nA
7
LN-1
LN
6
L3
L2
L1
5 TIMES
8
2C

FIG. 4

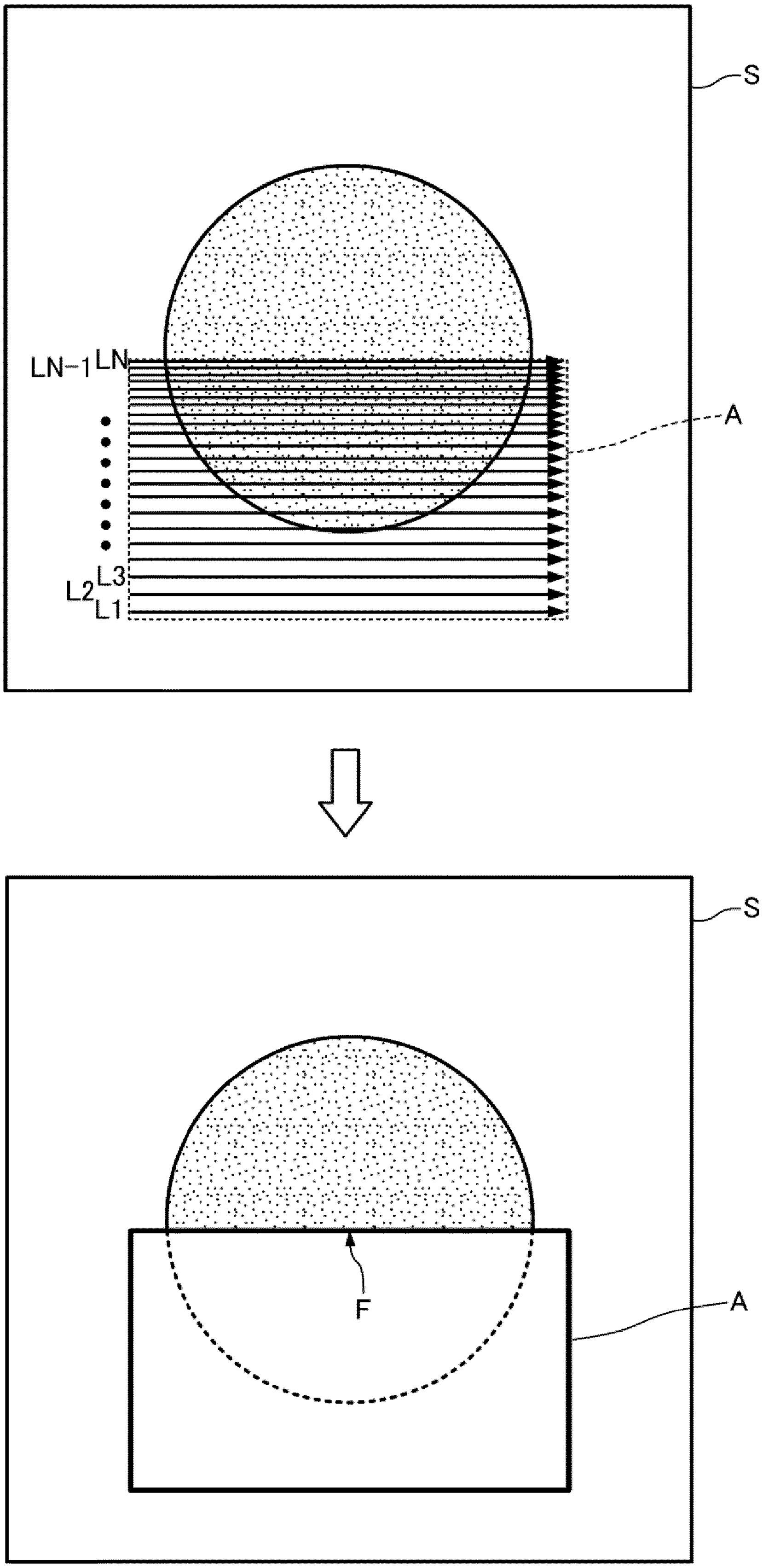


FIG. 5

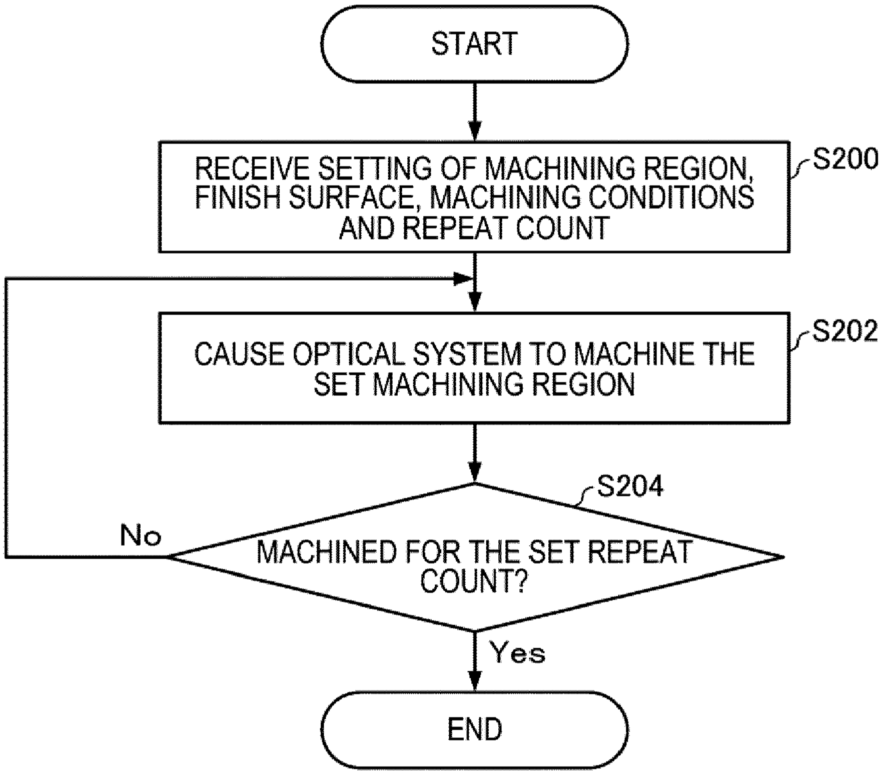
START
RECEIVE SETTING OF MACHINING REGION, FINISH SURFACE, MACHINING CONDITIONS AND REPEAT COUNT
S200
CAUSE OPTICAL SYSTEM TO MACHINE THE SET MACHINING REGION
S202
MACHINED FOR THE SET REPEAT COUNT?
S204
No
Yes
END

FIG. 6

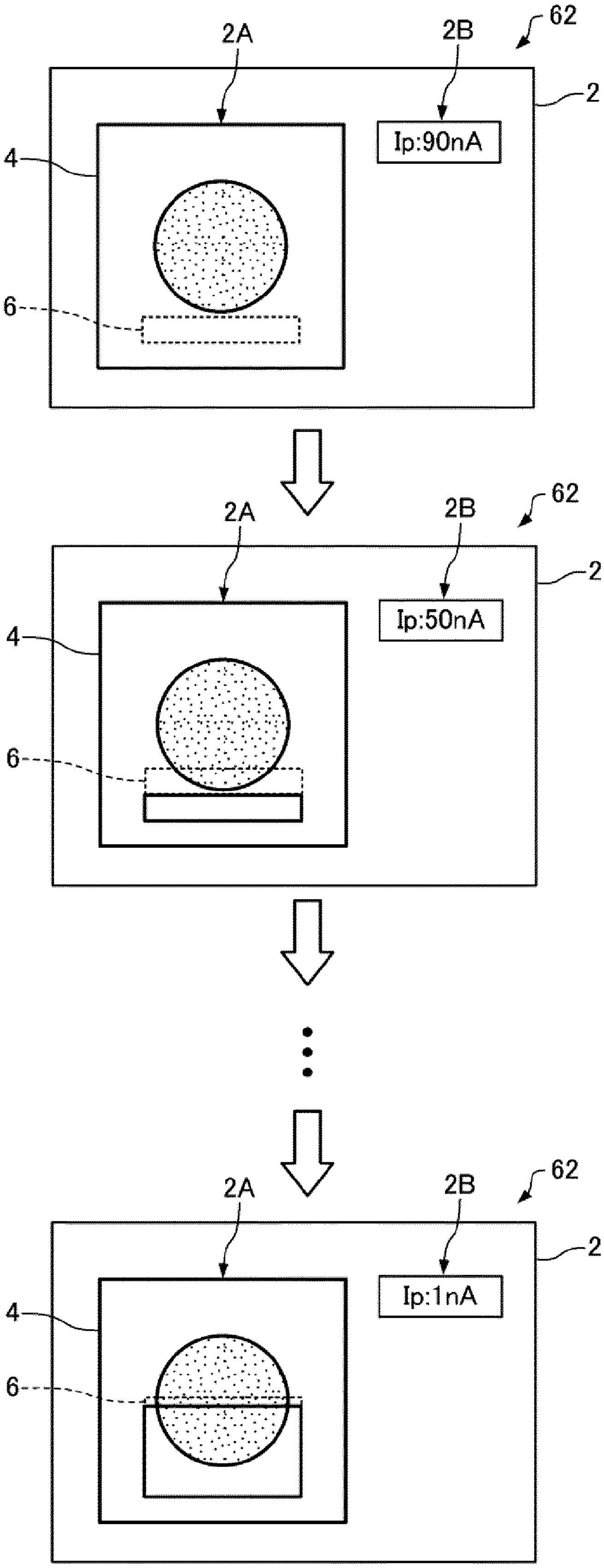


FIG. 7

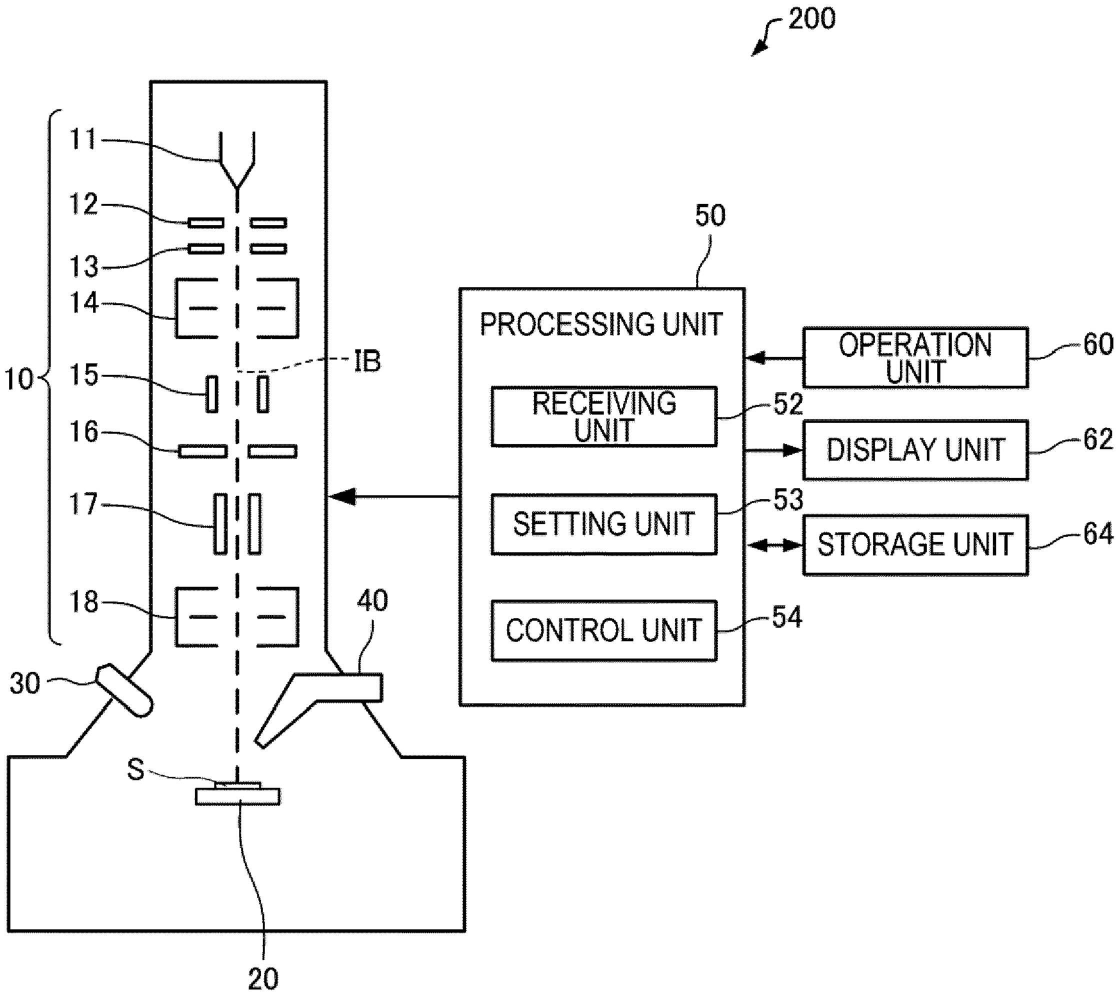
200
11
12
13
14
15
16
17
18
10
IB
30
40
S
20
50
PROCESSING UNIT
RECEIVING UNIT
52
SETTING UNIT
53
CONTROL UNIT
54
OPERATION UNIT
60
DISPLAY UNIT
62
STORAGE UNIT
64

FIG. 8

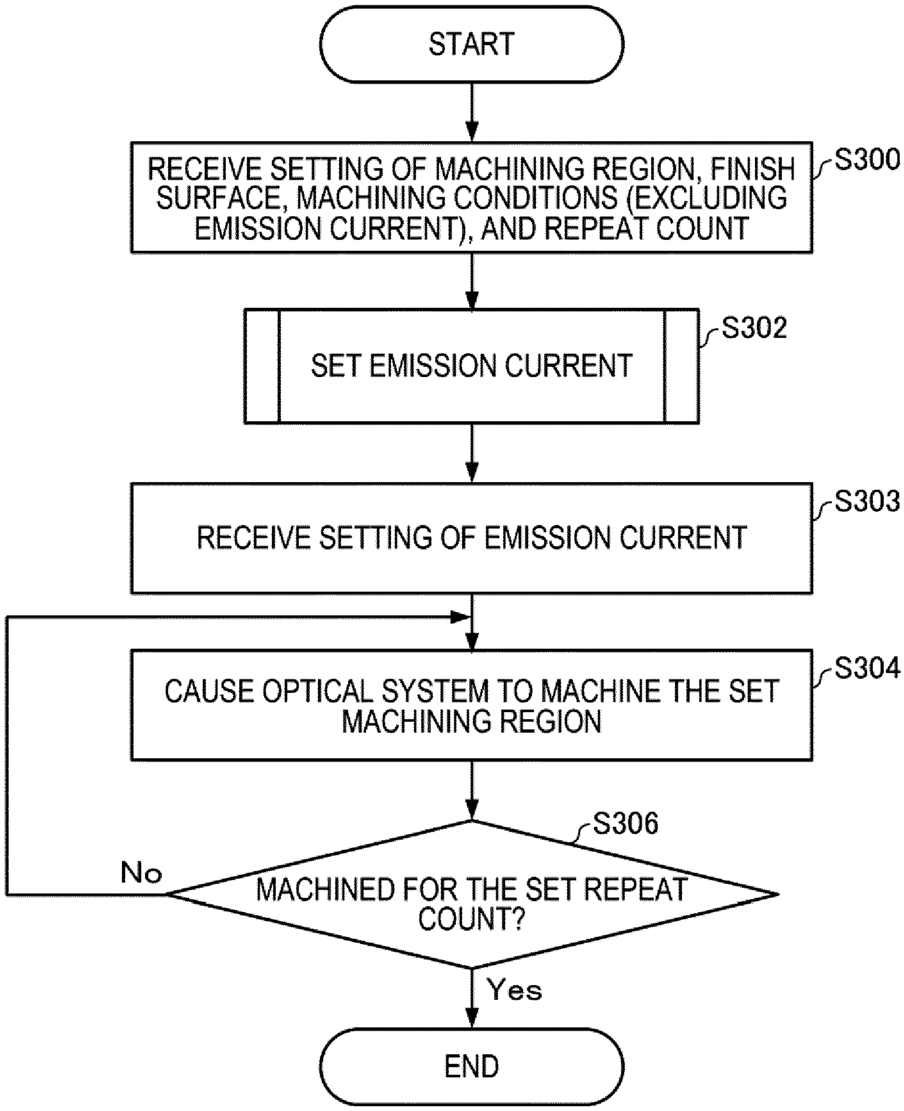
START
RECEIVE SETTING OF MACHINING REGION, FINISH SURFACE, MACHINING CONDITIONS (EXCLUDING EMISSION CURRENT), AND REPEAT COUNT
S300
SET EMISSION CURRENT
S302
RECEIVE SETTING OF EMISSION CURRENT
S303
CAUSE OPTICAL SYSTEM TO MACHINE THE SET MACHINING REGION
S304
MACHINED FOR THE SET REPEAT COUNT?
S306
No
Yes
END

FIG. 9

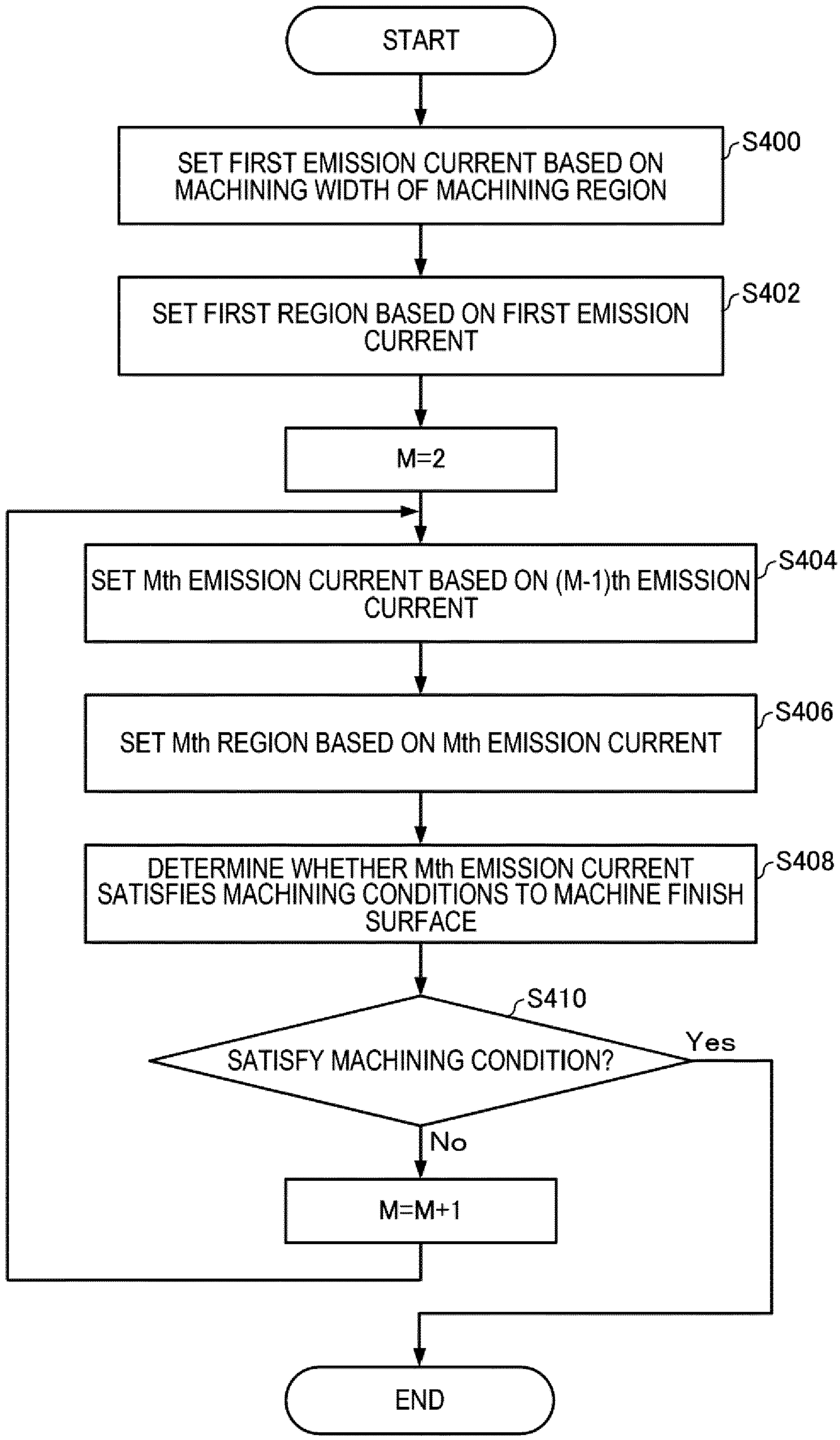
START
SET FIRST EMISSION CURRENT BASED ON MACHINING WIDTH OF MACHINING REGION
S400
SET FIRST REGION BASED ON FIRST EMISSION CURRENT
S402
M=2
SET Mth EMISSION CURRENT BASED ON (M-1)th EMISSION CURRENT
S404
SET Mth REGION BASED ON Mth EMISSION CURRENT
S406
DETERMINE WHETHER Mth EMISSION CURRENT SATISFIES MACHINING CONDITIONS TO MACHINE FINISH SURFACE
S408
SATISFY MACHINING CONDITION?
S410
Yes
No
M=M+1
END

FIG. 10

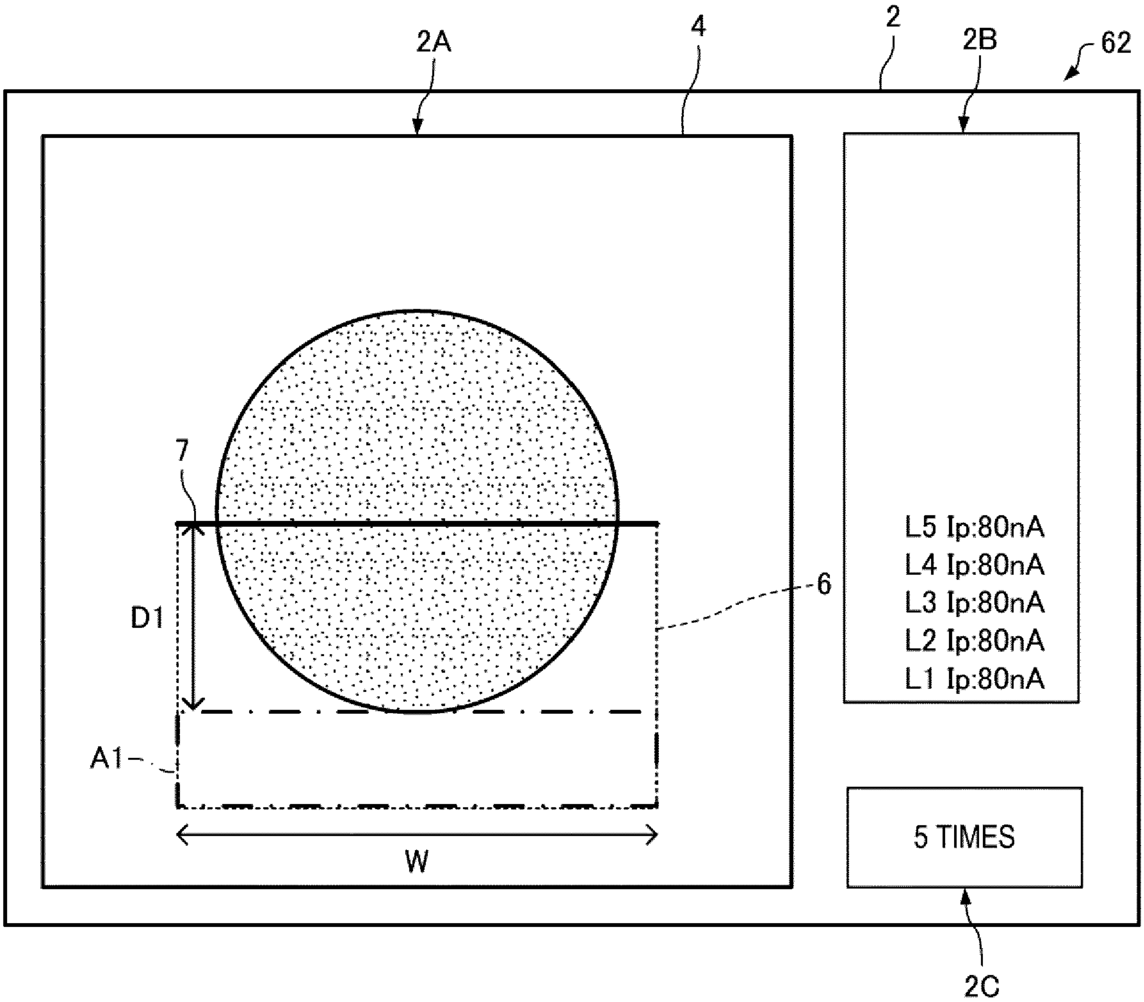
2A
4
2
2B
62
7
D1
A1
6
W
L5 Ip:80nA
L4 Ip:80nA
L3 Ip:80nA
L2 Ip:80nA
L1 Ip:80nA
5 TIMES
2C

FIG. 11

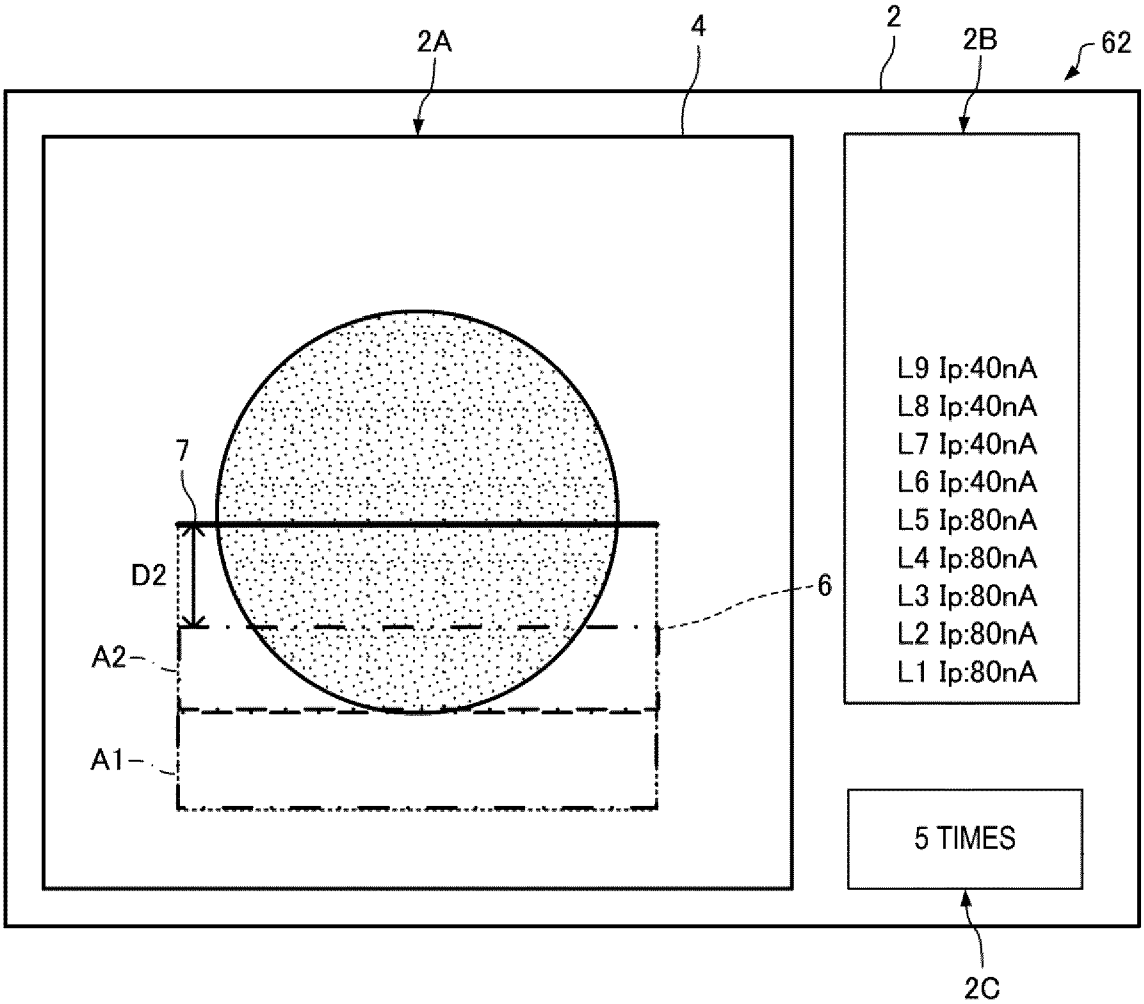
2A
4
2
2B
62
L9 Ip:40nA
L8 Ip:40nA
L7 Ip:40nA
L6 Ip:40nA
L5 Ip:80nA
L4 Ip:80nA
L3 Ip:80nA
L2 Ip:80nA
L1 Ip:80nA
7
D2
6
A2
A1
5 TIMES
2C

FIG. 12

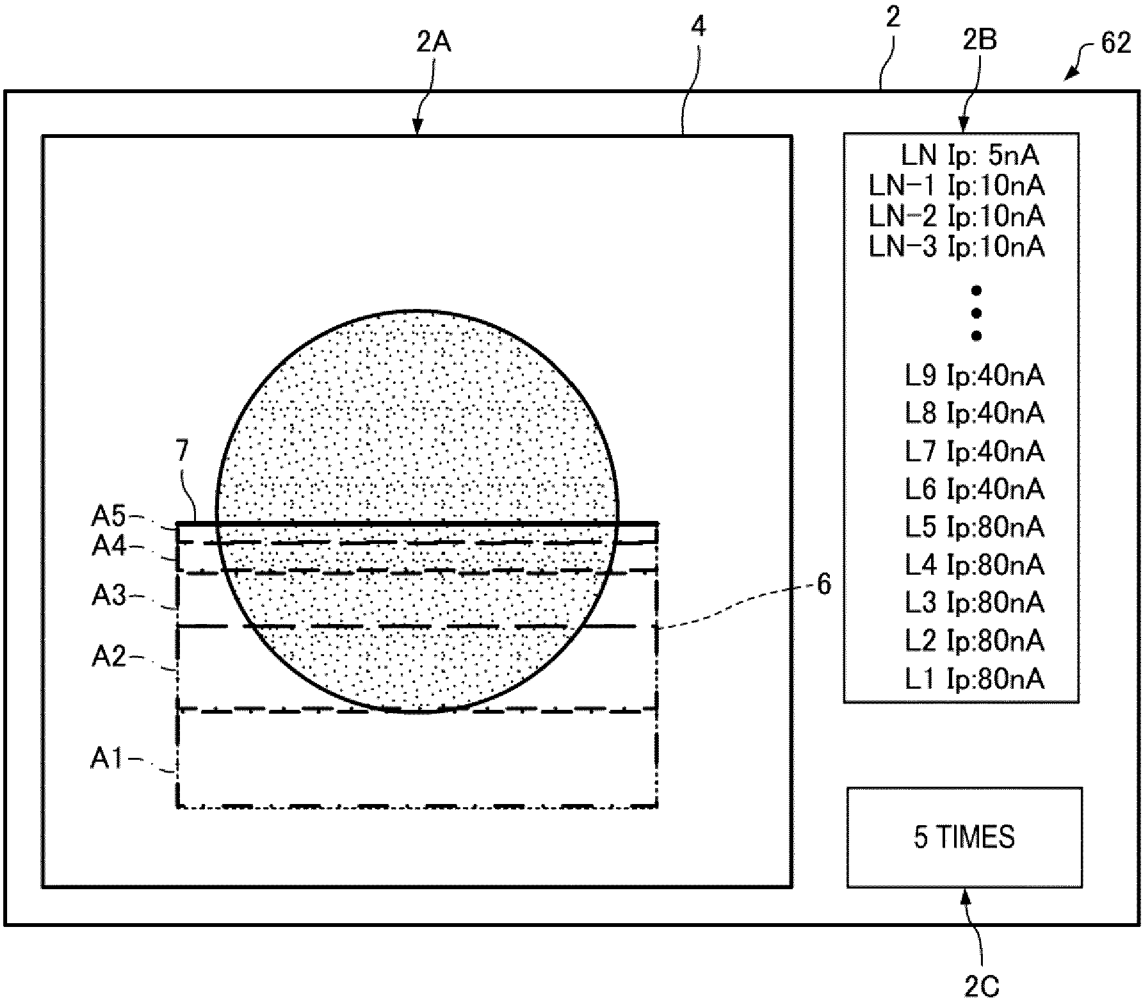
2A
4
2
2B
62
LN Ip: 5nA
LN-1 Ip:10nA
LN-2 Ip:10nA
LN-3 Ip:10nA
L9 Ip:40nA
L8 Ip:40nA
L7 Ip:40nA
L6 Ip:40nA
L5 Ip:80nA
L4 Ip:80nA
L3 Ip:80nA
L2 Ip:80nA
L1 Ip:80nA
7
A5
A4
A3
A2
A1
6
5 TIMES
2C

FIG. 13

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2006313704 A